# EUROPEAN PATENT APPLICATION

(11) **EP 4 671 029 A1**
(43) Date of publication of application: **31.12.2025**
(21) Application number: 25185161.4
(22) Date of filing: 25.06.2025
(51) Int. Cl.: B60L 3/00

(54) **SYSTEM FOR VERIFICATION OF ELECTRICAL INSULATION IN A MOTOR VEHICLE PROVIDED WITH A HIGH-VOLTAGE BATTERY**

(30) Priority: 26.06.2024 IT 202400014734
(71) Applicant: FERRARI S.p.A., 41100 Modena (IT)
(72) Inventor: FRANCO, Alberto, 41100 MODENA (IT); GENEROSI, Gianluca, 41100 MODENA (IT); AMODEO, Marco, 41100 MODENA (IT); SAENZ GONZALO, Alberto, 41100 MODENA (IT)
(74) Representative: Studio Torta S.p.A.

(57) **Abstract**

An insulation verification system (10) for a motor vehicle (1) provided with a high-voltage battery (5) connected to a high-voltage bus (12) is described, involving: a first insulation monitoring device (20), arranged inside the high-voltage battery (5), and managed and controlled by a corresponding BMS management module (9) of the high-voltage battery (5); a second insulation monitoring device (21), arranged outside the high-voltage battery (5); an insulation control unit (24), external to the high-voltage battery (5) and operatively coupled to the second insulation monitoring device (21) to manage its operation. The insulation control unit (24) implements a control logic of the insulation verification system (10) for verification of the electrical insulation of the high-voltage bus (12) involving an interaction, with cooperation without mutual interference, between the first and second insulation monitoring devices (20, 21).

## Description

### CROSS-REFERENCE TO RELATED APPLICATIONS

This patent application claims priority from Italian patent application no. 102024000014734 filed on June 26, 2024, the entire disclosure of which is incorporated herein by reference.

### TECHNICAL FIELD

The present solution relates to a system for verification of electrical insulation (or isolation) in a motor vehicle provided with a high-voltage battery, which allows improved safety performance.

### PRIOR ART

In a known manner, motor vehicles with electric or hybrid propulsion are provided with: an electric or hybrid propulsion assembly, which is designed to drag into rotation at least one wheel resting on the ground; a rechargeable high-voltage battery pack (or more simply battery), which is capable of accumulating a given amount of electric energy to be provided to the electric or hybrid propulsion assembly; and an electronically controlled inverter, which is interposed between the battery pack and the propulsion assembly and is designed to transform, as a function of commands given by the driver of the vehicle, the DC electric energy coming from the battery pack into AC electric energy for the propulsion assembly.

In a known manner, the high-voltage battery is internally provided with a management module, the so-called BMS module, a control unit which dialogues with the electronics of the vehicle and is designed to manage the operation and monitor the operating status of the battery, for example so as to prevent it from operating outside safety conditions. In particular, the BMS module is designed to control and manage the set of electrochemical cells which compose the battery, monitoring the charge status, temperature, voltage and/or other parameters thereof, in order to, for example, implement a balancing of the charge status in the event of an unbalance between the various electrochemical cells.

Since the batteries of the current motor vehicles can reach nominal voltages up to 800 V (generally operating at very high voltages, comprised between 400 and 800 V), it is important to have the possibility to detect ground faults that can compromise the electrical insulation.

Such faults may, for example, be due to ageing of the electrical components, to stresses of various nature (mechanical, electrical, thermal or environmental) or to accidents to which the high-voltage battery can be subject, such as for example a puncture of a corresponding hermetic housing wherein the electrolytic cells are accommodated.

When a ground fault occurs, a consequent significant reduction occurs in the electrical resistance associated with the insulation, which implies the flowing of a certain leakage current, the value of which is not negligible.

Such faults can thus be dangerous for the users and/or for low-voltage circuits of the vehicle sharing the same ground connection and can further cause a fire to start inside the motor vehicle, with possible even very serious consequences.

Therefore, the high-voltage batteries are usually internally provided with a ground fault detection (so-called GFD) circuit, capable of assessing (possibly by means of suitable estimates) the electrical resistance between the positive pole or terminal of the battery and ground and/or between the negative pole or terminal of the battery and ground, in particular operating conditions specified by current regulations.

Such ground fault detection circuit is typically included in the BMS module of the high-voltage battery. In this case, such BMS module also has the function of monitoring the above-mentioned insulation resistance, being for example configured to interrupt, by means of suitable circuit interruption elements, the supply of the loads by the battery, when it detects a variation of the insulation resistance potentially indicative of a ground fault.

The present Applicant has realized that, despite the important function performed, the above-mentioned ground fault detection circuit inside the BMS module, at least in given situations, may not guarantee a complete electrical safety with regard to the electrical insulation of the high-voltage components inside the motor vehicle, which include not only the above-mentioned high-voltage battery, but also inverters, DC/DC voltage converters, or in general other loads operating at high voltage or anyway coupled to a same high-voltage bus present in the motor vehicle.

In particular, the need to monitor in a complete manner the electrical insulation of the motor vehicle with respect to the high voltage is particularly felt in the case of prototype motor vehicles, since the prototypal nature generally makes faults or safety-critical situations more likely to arise.

### SUBJECT-MATTER OF THE INVENTION

The aim of the present solution is to provide an electrical insulation verification system, which may provide an answer to the above-mentioned need and in general may guarantee an increase in the electrical safety of the motor vehicle with respect to insulation losses with respect to the high voltage.

In accordance with this aim, according to the present solution, a system is provided as defined in the appended claims.

### BRIEF DESCRIPTION OF THE FIGURES

The present invention will now be described with reference to the accompanying drawings, which illustrate a non-limiting example embodiment thereof, wherein:
- Figure 1 schematically shows a motor vehicle provided with at least one electrical insulation verification system, in accordance with the present solution;
- Figure 2 shows a schematic block diagram of the electrical insulation verification system; and

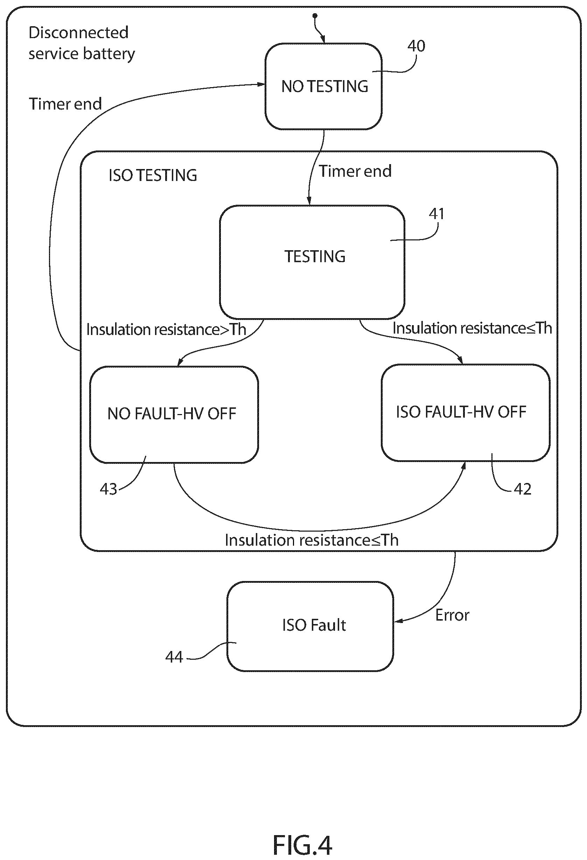

- Figures 3-4 show state diagrams relating to operations performed by the electrical insulation verification system.

### DETAILED DESCRIPTION OF THE EMBODIMENTS

As it will be described in detail in the following, an aspect of the present solution provides an electrical insulation verification system in a motor vehicle, which comprises: two electrical insulation monitoring devices, which are distinct and operate in an independent manner, a first device inside the high-voltage battery and a second device external to the high-voltage battery; and furthermore a control unit configured to implement a suitable cooperation (without mutual interference) between the two electrical insulation monitoring devices for verification of the electrical insulation with respect to the high voltage.

This system thereby allows a verification and a continuous monitoring of the electrical insulation in the motor vehicle with respect to the high voltage, in particular both when the contacts (or terminals) of the high-voltage battery are closed, i.e., connected to a high-voltage bus of the motor vehicle, and when the contacts are open, i.e., not connected to the high-voltage bus.

Furthermore, the electrical insulation verification system advantageously provides suitable user interface elements designed to signal in a continuous manner over time, in particular in a visual manner, the status of the electrical insulation to a user of the motor vehicle, so as to signal in an evident and timely manner possible electrical insulation losses or problems.

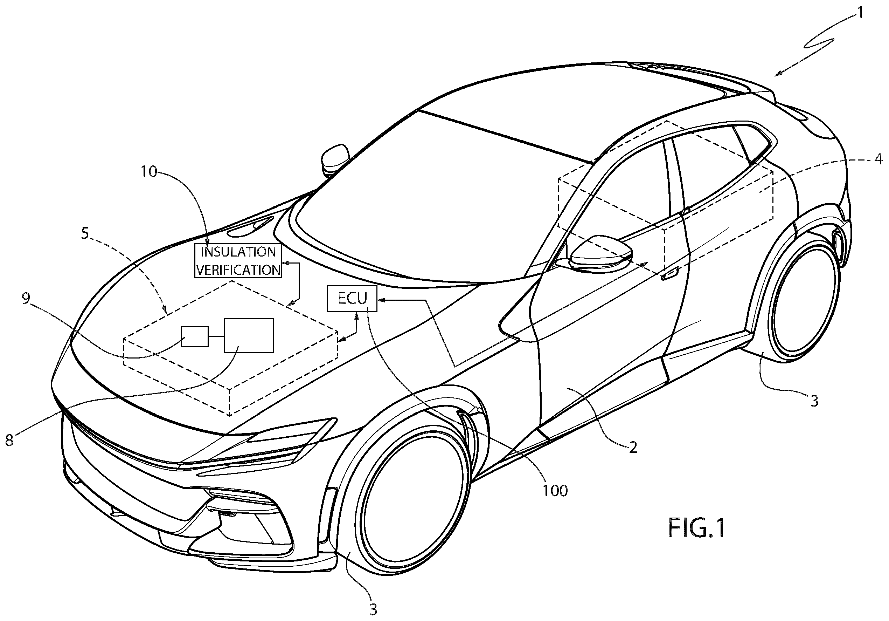

With reference first to Figure 1, reference numeral 1 denotes, as a whole, a motor vehicle, with electric or hybrid propulsion, having a body 2 resting on the ground by means of wheels 3 and comprising: an electric or hybrid propulsion assembly 4, including at least one synchronous or asynchronous electric motor, designed to drag into rotation at least one of such wheels 3 and the actuation of which is controlled by a control unit (ECU - Electronic Control Unit) 100, designed to further supervise the general operation of the motor vehicle 1 (in a known manner, not described in detail herein); and a high-voltage battery (HVB) 5, of a rechargeable type, which is capable of accumulating a given amount of electric energy to be provided to the above-mentioned propulsion assembly 4.

The propulsion assembly 4 and the high-voltage battery 5 are accommodated inside the body 2, in the illustrated example the electric or hybrid propulsion assembly 4 being arranged in a rear part and the high-voltage battery 5 in a front part of the body 2.

In a known manner, not illustrated herein, an electrical unit, in particular including an electronically controlled inverter, is interposed between the high-voltage battery 5 and the propulsion assembly 4 so as to transform, as a function of commands given by the driver of the vehicle, the DC electric energy coming from the high-voltage battery 5 into AC electric energy for the propulsion assembly 4.

The high-voltage battery 5 has, for example, a nominal capacity greater than or equal to 50 kWh and a nominal voltage comprised between 400 V and 800 volts, in particular equal to 800 V.

As is schematically shown in the above-mentioned Figure 1, the high-voltage battery 5 internally comprises a group of electrolytic cells 8 and a BMS module 9, operatively coupled to the group of electrolytic cells 8, for management and supervision of its operation.

According to an aspect of the present solution, the motor vehicle 1 further comprises an insulation verification system 10, schematically shown in Figure 1, operatively coupled to the high-voltage battery 5 and configured to verify in a continuous manner the electrical insulation of a corresponding high-voltage bus or line with respect to ground (it should be noted that, despite the schematic view, part of such insulation verification system 10 can be included in the high-voltage battery 5).

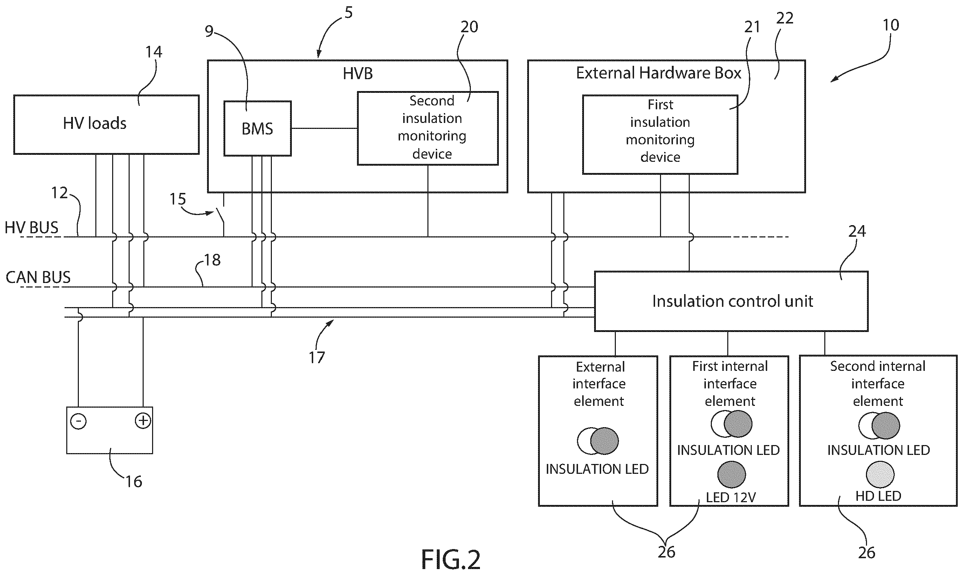

In greater detail, and as is schematically shown in Figure 2, the high-voltage battery 5 is coupled to a high-voltage bus 12, to which a plurality of high-voltage loads indicated in general by 14, for example inverters, DC/DC converters or the like, are also coupled inside the motor vehicle 1 (here not shown).

In particular, the high-voltage battery 5 is selectively coupled to the high-voltage bus 12 by means of connection terminals 15 (shown in a schematic manner); the above-mentioned BMS module 9 is configured to control the opening or closing of such connection terminals 15 so as to determine the disconnection, respectively the connection, of the high-voltage battery 5 to the high-voltage bus 12.

The motor vehicle 1 further comprises, in a known manner, a low-voltage service battery 16, for example having a nominal voltage of 12V, the positive and negative poles of which are coupled to a low-voltage line 17, with which a plurality of electrical services are associated inside the motor vehicle 1 (in a known manner, not illustrated in detail herein) .

The service battery 16 is further coupled to the high-voltage battery 5 and to the high-voltage loads 14.

The above-mentioned Figure 2 further shows the CAN (Controller Area Network) line or bus of the motor vehicle 1, indicated by 18, to which, among other elements, the above-mentioned BMS module 9 of the high-voltage battery 5 and the above-mentioned high-voltage loads 14 are coupled.

The insulation verification system 10 comprises a first insulation monitoring device 20, arranged inside the high-voltage battery 5, connected to the high-voltage bus 12 and managed and controlled by the corresponding BMS module 9.

Such first insulation monitoring device 20, of the hardware type, may be, in a known manner not described in detail herein, based on an electrical impedance measurement, being connected between the high-voltage bus 12 and ground and being configured to apply a measurement voltage and consequently assess the insulation resistance.

According to an aspect of the present solution, the insulation verification system 10 comprises a second insulation monitoring device 21, arranged externally to the high-voltage battery 5, in a proper box or housing 22, preferably in a position not accessible to the user of the motor vehicle 1, and connected to the high-voltage bus 12.

Also such second insulation monitoring device 21 is of the hardware type and may be based for example on an electrical impedance measurement, being connected between the high-voltage bus 12 and ground, to assess the insulation resistance associated with the high-voltage bus 12.

The second monitoring device 21 is further coupled to the service battery 16, as shown in the above-mentioned Figure **2****.**

The insulation verification system 10 further comprises an insulation control unit 24, arranged in a distinct and external position with respect to the above-mentioned high-voltage battery 5 and the above-mentioned housing 22 of the second insulation monitoring device 21 and operatively coupled to the second insulation monitoring device 21 for monitoring its operation and managing in general the operation of the insulation verification system 10.

Such insulation control unit 24 is further coupled to the service battery 16, as shown in the above-mentioned Figure 2, from which it receives electrical power supply.

In particular, the insulation control unit 24 comprises a microprocessor, microcontroller or similar digital processing unit, configured to execute a suitable control logic of the above-mentioned insulation verification system 10.

Such control logic is implemented by suitable software (firmware) executed by the insulation control unit 24 and stored, in the form of programming code, in a non-volatile memory (not illustrated herein) associated with the insulation control unit 24; in particular, the insulation control unit 24, when executing such software, is configured to implement the above-mentioned control logic.

The insulation control unit 24 of the insulation verification system 10, even if schematically shown herein distinct from the control unit 100 of the motor vehicle 1, could coincide, or be part of this control unit.

The insulation verification system 10 further comprises one or more user interface elements 26, arranged in a suitable manner inside and/or outside the motor vehicle 1 and controllable by the above-mentioned insulation control unit 24 to provide a user of the motor vehicle 1 in a continuous manner with an indication of the insulation status with respect to the high voltage. In particular, such user interface elements 26 are configured to provide a visual indication and comprise for such purpose one or more LEDs (Light Emitting Diode) or similar lighting elements, having one or more different colors.

In general, the insulation verification system 10 comprises at least one of such user interface elements 26; Figure 2 illustrates by way of example three user interface elements 26, which can for example be placed a first one external to the body 2 of the motor vehicle 1, for example on the roof; a second one inside the passenger compartment, for example at the windshield; and a third one also inside the passenger compartment, for example at the command dashboard.

In particular, such user interface elements 26 are configured to provide at least: a first indication, for example a visual indication via a first color, for example green, if the insulation verification system 10 does not determine the presence of a lack of insulation; and a second indication, for example visual via a second color, for example red, if the insulation verification system 10 determines the presence of a lack of insulation.

As it will be described in the following, one or more of the user interface elements 26 may include at least one further LED or similar lighting element, to indicate for example the correct connection of the service battery 16 and of the high-voltage battery 5.

In particular, the above-mentioned insulation control unit 24 is configured to manage the second insulation monitoring device 21 to implement the insulation verification with respect to the high voltage, when the connection terminals 15 of the high-voltage battery 5 are open and the high-voltage battery 5 is thus decoupled from the high-voltage bus 12.

Furthermore, when the connection terminals 15 of the high-voltage battery 5 are instead closed and the high-voltage battery 5 is thus coupled to the high-voltage bus 12 and provides the high voltage to the high-voltage bus 12, the insulation control unit 24 is configured to act as a simple interface between the first insulation monitoring device 20 and the user interface elements 26, in particular managing the operation of such user interface elements 26. In this condition, in fact, the insulation verification is entrusted to the first insulation monitoring device 20, suitably managed by the BMS module 9 of the high-voltage battery 5.

In particular, the insulation control unit 24 is configured to interrogate the CAN bus 18 of the motor vehicle 1 to determine if the high-voltage battery 5 has the above-mentioned connection terminals 15 open or closed and furthermore to receive from the BMS module 9 insulation status information.

It is highlighted that this architecture of the insulation verification system 10 and this operation by the insulation control unit 24 allows implementing a continuous monitoring of the electrical insulation with respect to the high voltage (in particular, between the high-voltage bus 12 and ground), via cooperation without interference between the first and the second insulation monitoring devices 20, 21.

In a possible implementation, the operation of the insulation control unit 24 provides for the implementation of a state machine, in which the transition between the states is determined by significant events for the monitoring of the electrical insulation.

The main states that can be assumed by the insulation control unit 24 are for example the following:
- 'NO FAULT - HV OFF': the high-voltage bus 12 is not energized (the connection terminals 15 of the high-voltage battery 5 are open) and the second insulation monitoring device 21 managed by the insulation control unit 24 has verified that the insulation resistance is above a preset insulation threshold Th, indicative of a safety condition (or absence of faults); the insulation control unit 24 therefore signals via the user interface elements 26 that the high-voltage system is safe;
- 'FAULT ISO - HV OFF': the high-voltage bus 12 is not energized and the second insulation monitoring device 21 has verified that the insulation resistance is below the preset insulation threshold Th; the insulation control unit 24 therefore signals via the user interface elements 26 that the high-voltage system is not safe;
- 'NO FAULT - HV ON': the high-voltage bus 12 is energized (the connection terminals 15 of the high-voltage battery 5 are closed), therefore the insulation control unit 24 acts as an interface, interfacing with the first insulation monitoring device 20 (which is entrusted in such case monitoring of the electrical insulation), and signals via the user interface elements 26 that the high-voltage system is safe (the excited bus does not have insulation losses);
- 'FAULT ISO - HV ON': the high-voltage bus 12 is energized and the insulation control unit 24 signals via the user interface elements 26 that the high-voltage system is not safe (the excited bus has undergone an insulation loss), having received a corresponding state information from the first insulation monitoring device 20.

In general, in the case where an insulation loss occurs, determined by the first insulation monitoring device 20 (inside the high-voltage battery 5) or by the second insulation monitoring device 21 (external to the high-voltage battery 5), the insulation control unit 24 signals the danger via the user interface elements 26 (for example by activating a fixed red signal).

In a possible implementation, further states that can be assumed by the insulation control unit 24 can be the following:
- 'NO TESTING': the insulation control unit 24 is not supplied, therefore it is not capable of making or managing insulation measurements (the supply at 12 V is not available since the service battery 16 is disconnected);
- 'TESTING': the insulation control unit 24 is supplied and verifies if the connection terminals 15 of the high-voltage battery 5 are open or closed, if open, it starts monitoring of the insulation on the high-voltage bus 12 via the second insulation monitoring device 21;
- 'ISO FAULT': this state substantially indicates that at least one of the first and the second insulation monitoring devices 20, 21 has an internal problem and is not capable of making a correct measurement of the insulation of the motor vehicle 1;
- 'VEHICLE FAULT': in this state, the insulation control unit 24 indicates to the user that there is a general problem with the motor vehicle 1, which does not allow a correct measurement of the electrical insulation.

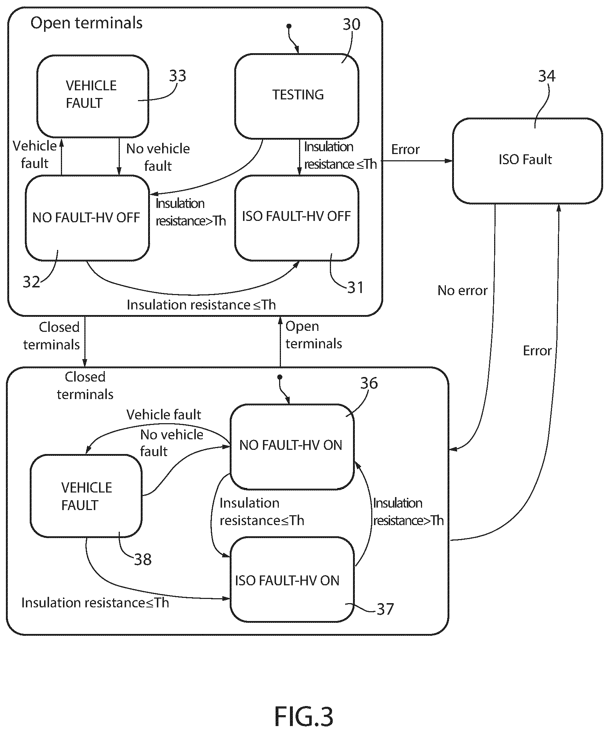

With reference to Figure 3, a possible transition diagram of the states which can be implemented by the insulation control unit 24 is now illustrated; such state diagram is simplified for sake of illustration simplicity and refers to the sole main states that can be assumed by the insulation control unit 24. Furthermore, in the illustrated example, it is assumed that the user interface elements 26 comprise at least: a first LED, designed to indicate the status of connection of the high-voltage battery 5 to the high-voltage bus 12; and a secondo LED, designed to indicate the status of the detected electrical insulation.

In detail, in the hypothesis that the service battery 16 is correctly connected in the motor vehicle 1 and provides the service supply at 12 V, supplying, among other elements, the insulation control unit 24, and furthermore that the connection terminals 15 are open, a first state assumed by the insulation control unit 24 is indicated by 30 and corresponds to the above-mentioned 'TESTING' state.

In this state, for example, the first and second LEDs can assume a respective flashing color.

From the state 30, the diagram evolves into the state 31, which corresponds to the above-mentioned 'FAULT ISO - HV OFF' state, in the case where the second insulation monitoring device 21 has verified that the insulation resistance is below the preset insulation threshold Th.

In this state, for example, the first LED is turned off and the second LED assumes a fixed red color.

From the above-mentioned state 30, the diagram evolves instead into the state 32, which corresponds to the above-mentioned 'NO FAULT - HV OFF' state, in the case where the second insulation monitoring device 21 has verified that the insulation resistance is above the preset insulation threshold Th.

In this state, for example, the first LED is turned off and the second LED assumes a fixed green color.

From the state 32, the diagram can evolve into the state 31, as soon as the second insulation monitoring device 21 verifies that the insulation resistance is below the preset insulation threshold Th.

Furthermore, from the state 32, the diagram can evolve into the state 33, which corresponds to the above-mentioned 'VEHICLE FAULT' state, in the case where the insulation control unit 24 verifies the presence of a fault to the motor vehicle 1 (for example, by means of a corresponding information on the CAN bus 18).

In this state, for example, the first LED can assume a fixed color, for example orange, and the second LED can assume a respective fixed color, for example yellow, different from the green or red color assumed in the preceding cases.

From such state 33, the diagram can again evolve into the state 32, in the case where the fault to the motor vehicle 1 is no longer detected.

Furthermore, from each of the above-mentioned states 30-33, the diagram can evolve towards a state 34, which corresponds to the above-mentioned 'ISO FAULT' state, in the case where the insulation control unit 24 verifies the presence of an internal problem for the first or second insulation monitoring device 20, 21, not being thus able to make a correct measurement of the insulation of the vehicle.

In this state, for example, the first LED can assume a flashing orange color and the second LED can assume a flashing red color.

In the hypothesis instead that the connection terminals 15 are closed, the state diagram evolves towards a state 36, which corresponds to the above-mentioned 'NO FAULT - HV ON' state. It should be noted that such state 36 can possibly be the starting state of the state diagram, instead of the above-mentioned state 30.

Furthermore, from such state 36 there is a return to the above-mentioned state 30 when the connection terminals 15 are open.

In such state 36, as discussed in the foregoing, the insulation control unit 24 acts as an interface and the insulation verification is entrusted to the first insulation monitoring device 20.

In this state 36, for example, the first LED can assume a fixed orange color and the second LED can assume a fixed green color.

From the state 36, the diagram evolves into the state 37, which corresponds to the above-mentioned 'FAULT ISO - HV ON' state, in the case where the first insulation monitoring device 20 has verified that the insulation resistance is below the preset insulation threshold Th (the insulation control unit 24 receives such information from the CAN bus 18 and consequently controls the user interface elements 26) .

In particular, for example, the first LED assumes a fixed orange color and the second LED assumes a fixed red color.

From the above-mentioned state 36, the state diagram may instead evolve into the state 38, which corresponds to the above-mentioned 'VEHICLE FAULT' state, in the case where the insulation control unit 24 verifies the presence of a fault to the motor vehicle 1.

In this state 38, for example, the first LED can assume a fixed color, for example orange, and the second LED can assume a respective fixed color, for example yellow.

From such state 38, the state diagram may evolve into the state 37, in the case where the first insulation monitoring device 20 verifies that the insulation resistance is below the preset insulation threshold Th; or into the state 36, in the case where the absence of faults to the motor vehicle 1 occurs.

As discussed in the foregoing, the diagram can also evolve from the states 36-38 towards the state 34, of 'ISO FAULT', in the case where the insulation control unit 24 verifies the presence of an internal problem, in this case for the first insulation monitoring device 20.

From the state 34 there is furthermore a return to the state 36, in the case where the problem to the insulation monitoring device is no longer present (and the connection terminals 15 are still closed).

In a manner that is not described in detail so as not to burden the discussion, the state diagram may include further states and state transitions for also describing the transitions between further states which can be assumed by the insulation control unit 24.

Furthermore, the user interface elements 26 can include further LEDs with the corresponding visual indications; for example, a further LED can be used for indicating the connection of the service battery 16 to the motor vehicle 1.

To this regard, Figure 3 shows a further portion of the state diagram, relative to the management of the situation in which the service battery 16 is disconnected from the motor vehicle 1.

In this condition, also the high-voltage bus 12 is not energized; consequently, the insulation control unit 24 manages the second insulation monitoring device 21 for verifying the insulation with respect to the high voltage.

In detail, a first state, indicated by 40, corresponds to the above-mentioned 'NO TESTING' condition; a third LED can be turned on, for example with a fixed color, for indicating the disconnected condition of the service battery 16.

In a possible implementation, exit from such state 40 can be determined by the end of a first counting by a counter inside the insulation control unit 24, which thus brings to a state 41, which corresponds to the above-mentioned 'TESTING' state (such first counter can correspond to a preset inactivity, or sleep, interval of the insulation control unit 24, for example of the duration of a couple of hours).

In this state, the first and the second LEDs can assume a respective flashing color; the third LED maintains the above-mentioned fixed color.

From the state 41, the diagram evolves into the state 42, which substantially corresponds to the above-mentioned 'FAULT ISO - HV OFF' state, in the case where the second insulation monitoring device 21 has verified that the insulation resistance is below the preset insulation threshold Th.

In this state, for example, the first LED is turned off and the second LED assumes a fixed red color; the third LED maintains the above-mentioned fixed color.

From the above-mentioned state 41, the diagram evolves instead into the state 43, which substantially corresponds to the above-mentioned 'NO FAULT - HV OFF' state, in the case where the second insulation monitoring device 21 has verified that the insulation resistance is above the preset insulation threshold Th.

In this state, for example, the first LED is turned off and the second LED assumes a fixed green color; the third LED maintains the above-mentioned fixed color.

From the state 43, the diagram can evolve into the state 42, as soon as the second insulation monitoring device 21 verifies that the insulation resistance is below the preset insulation threshold Th.

Furthermore, from each of the above-mentioned states 41-43, the diagram can evolve towards a state 44, which corresponds to the above-mentioned 'ISO FAULT' state, in the case where the insulation control unit 24 verifies the presence of a problem, in this case for the second insulation monitoring device 21, not being thus able to make a correct measurement of the electrical insulation of the vehicle.

In this state, for example, the first LED can assume a flashing orange color and the second LED can assume a flashing red color; the third LED maintains the above-mentioned fixed color.

From the states 41-43, the diagram can further evolve again towards the initial state 40, in the case where the counter inside the insulation control unit 24 reaches the end of a second counting, typically having a duration shorter than the above-mentioned first counting (such duration corresponding to the execution of the control of the insulation, for example of approximately 20 seconds).

Based on what has been discussed, the advantages that the present solution allows to obtain are evident.

In any case, it is highlighted that the described solution allows monitoring in a complete and continuous manner over time the electrical insulation of the motor vehicle with respect to the high voltage, in all possible conditions, comprising those in which the high-voltage battery is not connected to the high-voltage bus.

The described solution thus allows increasing the electrical safety of the motor vehicle with regard to insulation losses from the high voltage, being particularly advantageous in the case of when used in motor vehicles of prototypal type.

In particular, as discussed in the foregoing, the interaction with cooperation without interference between the first and the second insulation monitoring devices 20, 21 managed by the insulation control unit 24 proves to be particularly advantageous.

Furthermore, the presence of the user interface elements 26, arranged so as to be always visible by the user, both when on board the motor vehicle 1 and when outside the motor vehicle 1, proves to be advantageous.

Furthermore, the described solution is simple and cost-effective to implement, not requiring in general substantial modifications to the motor vehicle 1.

Finally, it is clear that modifications and variations can be made to what described without thereby departing from the scope of the present invention, as defined by the appended claims.

It is highlighted in particular that the described solution can be advantageously applied also to standard or production motor vehicles, besides the case indicated in the foregoing of motor vehicles of prototypal type.

## Claims

1. An insulation verification system (10) for a motor vehicle (1) provided with a high-voltage battery (5) connected to a high-voltage bus (12), comprising:
a first insulation monitoring device (20), arranged inside the high-voltage battery (5), and managed and controlled by a corresponding BMS management module (9) of the high-voltage battery (5);
a second insulation monitoring device (21), arranged externally to the high-voltage battery (5);
an insulation control unit (24), external to the high-voltage battery (5) and operatively coupled to the second insulation monitoring device (21) to manage its operation,
wherein said insulation control unit (24) is configured to implement a control logic of the insulation verification system (10) for verification of the electrical insulation of said high-voltage bus (12) involving an interaction, with cooperation without mutual interference, between the first and second insulation monitoring devices (20, 21).

2. The system according to claim 1, wherein said high-voltage battery (5) is selectively coupled to the high-voltage bus (12) by means of connection terminals (15); and wherein said insulation control unit (24) is configured to implement said electrical insulation verification in a continuous manner, both when the connection terminals (15) of the high-voltage battery (5) are closed, i.e., connected to the high-voltage bus (12) of the motor vehicle (1), and when the connection terminals (15) are open, i.e., not connected to the high-voltage bus (12).

3. The system according to claim 1 or 2, wherein said insulation control unit (24) is configured to implement said insulation verification via said second insulation monitoring device (21), in a manner independent of said first insulation monitoring device (20), in the case where said connection terminals (15) are open; and to act as an interface towards said BMS management module (9) in the case where said connection terminals (15) are closed, said insulation control unit (24) being in such case configured to receive from said BMS management module (9) a result of the insulation verification carried out via the first insulation monitoring device (20), in a manner independent of said second insulation monitoring device (21).

4. The system according to claim 2 or 3, wherein said insulation control unit (24) is operatively coupled to said BMS management module (9) via a CAN, Controller Area Network, bus (18) inside said motor vehicle (1).

5. The system according to claim 4, wherein said insulation control unit (24) is further configured to receive from said CAN bus (18) indications of faults of said motor vehicle (1) and to signal an inability to implement said insulation verification in the event of occurrence of said faults.

6. The system according to any one of the preceding claims, wherein said insulation control unit (24) is further configured to signal an inability to implement said insulation verification in the event of problems to said first and/or second insulation monitoring device (20, 21).

7. The system according to any one of the preceding claims, further comprising one or more user interface elements (26) arranged inside and/or outside the motor vehicle (1) and controlled by said insulation control unit (24) to provide an electrical-insulation status indication to a user of the motor vehicle (1).

8. The system according to claim 7, wherein said user interface elements (26) are configured to provide a visual indication of at least a lack of electrical insulation of said high-voltage bus (12) with respect to a ground terminal of said motor vehicle (1) and comprise for this purpose one or more lighting elements, having one or more different colors.

9. The system according to claim 8, wherein said lighting elements are arranged inside the passenger compartment of the motor vehicle (1), at the dashboard and/or windshield, and outside the passenger compartment, at the roof.

10. The system according to any one of the preceding claims, wherein said second insulation monitoring device (21) is arranged externally to the high-voltage battery (5) in a corresponding box or housing (22), connected to the high-voltage bus (12); and wherein said insulation control unit (24) is arranged in a distinct external position with respect to said housing (22).

11. The system according to any one of the preceding claims, wherein said motor vehicle (1) is further provided with a low-voltage service battery (16) designed to be coupled to a service supply line (17) inside said motor vehicle (1); and wherein said insulation control unit (24) is coupled to the service battery (16) and is configured to implement said insulation verification via said second insulation monitoring device (21) even in the event that said service battery (16) is not connected to said service line in said motor vehicle (1).

12. The system according to any one of the preceding claims, wherein said first and second insulation monitoring devices (20, 21) are of the hardware type, based on an electrical impedance measurement of said high-voltage bus (12) with respect to a ground terminal of said motor vehicle (1).

13. An automotive control software storable in, and executable by, electronic processing resources and designed to cause, when executed, the electronic processing resources to become configured to implement the insulation control unit (24) of the insulation verification system (10) according to any one of the preceding claims.

14. A motor vehicle (1), provided with a high-voltage battery (5) connected to a high-voltage bus (12), comprising the insulation verification system (10) according to any one of claims 1-12.

15. The motor vehicle according to claim 14, of a prototypal type.
